(19) **Europäisches Patentamt European Patent Office Office européen des brevets**

(11) **EP 4 776 288 A1**

(12) **EUROPEAN PATENT APPLICATION**

(43) Date of publication:
15.07.2026 Bulletin 2026/29

(51) International Patent Classification (IPC):
*G11C 11/16* (2006.01)   *G11C 19/08* (2006.01)

(21) Application number: 25150712.5

(52) Cooperative Patent Classification (CPC):
G11C 11/1675; G11C 19/0808; G11C 19/0833

(22) Date of filing: 08.01.2025

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Max-Planck-Gesellschaft zur Förderung der Wissenschaften e.V.**
**80539 München (DE)**

(72) Inventors:
• **FISCHER, Lukas**
  06114 Halle (DE)
• **PARKIN, S.P., Stuart**
  06118 Halle (DE)
• **JEON, Jaechun**
  06108 Halle (DE)

(74) Representative: **Schweitzer, Klaus et al**
**Dr. Müller Patentanwälte**
**Mühlstraße 9A**
**65597 Hünfelden (DE)**

(54) **RESONANT DOMAIN WALL EXCITATION, ITS USE IN MEMORY DEVICES AND LOGIC ARCHITECTURE AND METHODS FOR GENERATING RESONANT DOMAIN WALL EXCITATION**

(57) The present invention relates to a localized magnetization precession of a chiral Néel domain wall (DW) at a distinct resonance frequency of 450 MHz that is far below the FMR mode (9.5 GHz). The Invention further relates to the modification of the DW motion upon the excitation of this DW resonance. In particular, the stimulation of the DW resonance in a static transverse magnetic field leads to self-propulsion of the DW without the need of a direct electrical current. Moreover, the stimulation in a static longitudinal magnetic field, which leads to a current-triggered sustained propulsion of DWs, reveals a significant enhancement in efficiencies for both a symmetric, currentinduced DWM and SOT induced magnetization switching.

Figure S1

## Description

The present invention relates to the efficient and tunable motion of magnetic domain walls (DWs) and their significance for the performance of DW-based spintronic devices proposed for advanced memory (e.g. in Racetrack Memory, or RTM applications) or logic architecture. Furthermore, the invention relates to resonant excitation of a magnetic domain wall (DW) resonance in different configurations.

Any memory or storage device must meet the three essential requirements of (i) being able to write information, (ii) being able to address and read the information, and (iii) being able to store information.

Existing and currently used storage devices like hard disk drives (HDDs) will not offer enough capacity for the growing data volumes. Moreover, the power consumption arising from the mechanical motion and the seeking speed are also some obstacles for HDDs. The RTM application appears to be a potential candidate for solving existing problems. In RTM, the magnetic DWs, that separate oppositely aligned magnetic bits, are moved along the magnetic conduit. Read and write operations are then performed at stationary ports (unlike the physical movement of the read/write head in HDD). The shifting of DWs appears to be a major field of interest for further development and improvement of such devices.

Chiral domain walls and their synchronous motion via current pulses in magnetic conduits (so-called magnetic racetracks) are of enormous interest due to their fast speed, non-volatility, and capability of creating high bit-density for advanced memory and logic technologies (1. S. S. Parkin, M. Hayashi, L. Thomas, Magnetic domain-wall racetrack memory. Science 320 (5873), 190-194 (2008); Z. Luo, A. Hrabec, T. Dao, G. Sala, Current-driven magnetic domain-wall logic. Nature 579 (7798), 214-218 (2020); Q. Shao, et al., Roadmap of spin-orbit torques. IEEE Trans. Magn. 57 (7), 1-39 (2021); D. Kumar, T. Jin, R. Sbiaa, M. Kläui, S. Bedanta, Domain wall memory: Physics, materials, and devices Phys. Rep. 958, 1-35 (2022); G. Venkat, D. A. Allwood, T. J. Hayward, Magnetic domain walls: types, processes and applications. J. Phys. D: Appl. Phys. 57 (6), 063001 (2023); J.-C. Jeon, A. Migliorini, L. Fischer, J. Yoon, S. S. P. Parkin, Dynamic manipulation of chiral domain wall spacing for advanced spintronic memory and logic devices. ACS Nano 18 (22), 14507-14513 (2024)). Over the past several decades an order of magnitude increase in the DW velocity for the same current density has been enabled by the discovery of new physical phenomena such as spin-orbit torques (SOT) (I. M. Miron, et al., Fast current-induced domain-wall motion controlled by the Rashba effect, Nat. Mater. 10 (6), 419-423 (2011); K.-S. Ryu, L. Thomas, S.-H. Yang, S. Parkin, Current induced tilting of domain walls in high velocity motion along perpendicularly magnetized micron-sized Co/Ni/-Co racetracks. Appl. Phys. Expr. 5 (9), 093006 (2012); S. Emori, U. Bauer, S.-M. Ahn, E. Martinez, G. Beach, Current-driven dynamics of chiral ferromagnetic domain walls. Nat. Mater. 12 (7), 611-616 (2013); K.-S. Ryu, L. Thomas, S.-H. Yang, S. Parkin, Chiral spin torque at magnetic domain walls, Nat. Nanotechnol. 8 (7), 527-533 (2013); S. Vélez, et al., High-speed domain wall racetracks in a magnetic insulator. Nat. Commun. 10 (1) (2019)) and novel exchange torques in synthetic antiferromagnets (S.-H. Yang, K.-S. Ryu, S. Parkin, Domain-wall velocities of up to 750 m s-1 driven by exchange-coupling torque in synthetic antiferromagnets. Nat. Nanotechnol. 10 (3), 221-226 (2015)). Most experimental and numerical studies have focused on the motion of the DWs using current pulses that are nanoseconds long and cannot efficiently couple to magnetization precessions of the material that typically occur in the GHz regime. It is noteworthy that the resonant excitation of magnetization enables microwave-assisted field-induced switching of magnetic domains and makes possible the writing of magnetic materials with very high magnetic anisotropy that would otherwise be impossible to write (J.-G. Zhu, X. Zhu, Y. Tang, Microwave assisted magnetic recording. IEEE Trans. Magn. 44 (1), 125-131 (2008); S. Okamoto, N. Kikuchi, M. Furuta, O. Kitakami, T. Shimatsu, Switching behaviors and its dynamics of a Co/Pt nanodot under the assistance of rf fields. Phys. Rev. Lett. 109 (23), 237209 (2012)). Interestingly, the corresponding effect of microwave fields on the current-induced domain wall motion (DWM) has not yet been explored. The resonant excitation of localized magnetic textures, such as DWs, is fundamentally different from that of the uniform material (K. Wagner, et al., Magnetic domain walls as reconfigurable spin-wave nanochannels. Nat. Nanotechnol. 11 (5), 432-436 (2016)). The dynamics of such DWs are often treated using a simplified set of differential equations (A. P. Malozemoff, J. C. Slonczewski, Magnetic domain walls in bubble materials: advances in materials and device research. Academic Press (1979); A. Thiaville, J. M. Garcia, J. Miltat, Domain wall dynamics in nanowires. J. Magn. Magn. Mater. 242, 1061-1063 (2002)) that indicate a link between spin precession within the DW and its motion. The dynamical phenomena are however highly affected by the magnetic material properties such as Dzyaloshinskii-Moriya interaction (A. Thiaville, S. Rohart, E. Jué, V. Cros, A. Fert, Dynamics of Dzyaloshinskii domain walls in ultrathin magnetic films. Europhys. Lett. 100 (5), 57002 (2012)).

Here we discuss only chiral Néel DWs in suitably engineered perpendicularly magnetized racetracks, commonly used for cutting-edge DW-based spintronic devices. In such DWs the magnetization rotates perpendicular to the DW plane and has a defined rotational sense. We note that the current-induced motion of Néel DWs by SOT (S. Emori, U. Bauer, S.-M. Ahn, E. Martinez, G. Beach, Current-driven dynamics of chiral ferromagnetic domain walls. Nat. Mater. 12 (7), 611-616 (2013); K.-S. Ryu, L. Thomas, S.-H. Yang, S. Parkin, Chiral spin torque at magnetic domain walls. Nat. Nanotechnol. 8 (7), 527-533 (2013); A. Thiaville, S. Rohart, E. Jué, V.

Cros, A. Fert, Dynamics of Dzyaloshinskii domain walls in ultrathin magnetic films. Europhys. Lett. 100 (5), 57002 (2012)) is entirely distinct from the motion of DWs in the form of magnetic bubbles driven by a magnetic field (A. P. Malozemoff, J. C. Slonczewski, Magnetic domain walls in bubble materials: advances in materials and device research. Academic Press (1979); N. L. Schryer, L. R. Walker, The motion of 180° domain walls in uniform dc magnetic fields. J. Appl. Phys. 45 (12), 5406-5421 (1974); B. E. Argyle, S. Maekawa, P. Dekker, J. C. Slonczewski, Gradientless propulsion and state switching of bubble domains. AIP Conf. Proc. (1976)). Because of this, we expect the dynamics of chiral Néel DWs to behave significantly different from earlier studies on either Bloch walls or DWs in thick, soft magnetic films.

Summary of the invention

In this context, the inventors first demonstrate the presence of a localized magnetization precession of a chiral Néel DW at a distinct resonance frequency of 450 MHz that is far below the FMR mode (9.5 GHz). Then the modification of the DW motion upon the excitation of this DW resonance is investigated. By resonantly stimulating the DW in the presence of a static, transverse magnetic field, a unidirectional motion of the DW without need of electrically induced spin orbit torque has been achieved. Moreover, the stimulation of the DW resonance in a static, longitudinal magnetic field reveals a significant enhancement in efficiencies for both a symmetric, current-induced DWM and SOT induced magnetization reversal.

Brief description of the figures

Fig. 1. Domain Wall schematic and sample design.

(A) Schematic of the different excitation modes and frequencies occurring in the uniform domains and the domain wall itself. (B) Schematic of the device setup and the electrical and optical operation during measurement. (C) Microscope images of a typical device.

Fig. 2. Magneto-optic microscopy of domain and DW dynamics.
SNS-MOKE data of a magnetic microwire hosting two chiral Néel walls. Top row: (A) In the L-MOKE configuration, the setup is sensitive to the x-component of the magnetization precession and probes the FMR mode in the out-of-plane domains. (B) The L-MOKE map shows a strong signal in the uniform domains but yields zero signal at the DW itself. A sign change (phase shift of 180°) is revealed when crossing a DW. The DW is visible as a narrow white line with zero signal. (C) The frequency scan has been measured in the uniformly magnetized domain at the center. The shaded area in (C) and (F) indicates the standard deviation determined from multiple measurements at each frequency. Bottom row: The P-MOKE configuration probes the z-component of the magnetization precession (cf. (D)). (E) This method is insensitive to the FMR mode in the uniform domains and only detects a precession or oscillation of the DW. Hence, the P-MOKE data only returns a signal at the DW position. (F) The frequency scan of the P-MOKE response at the DW position is shown on the left-hand side.

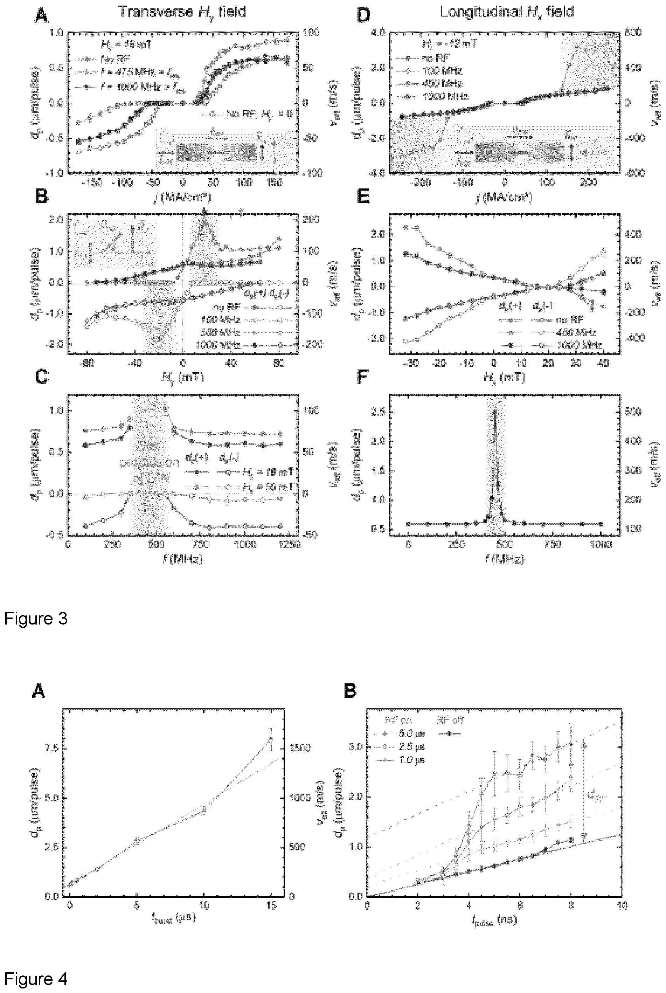

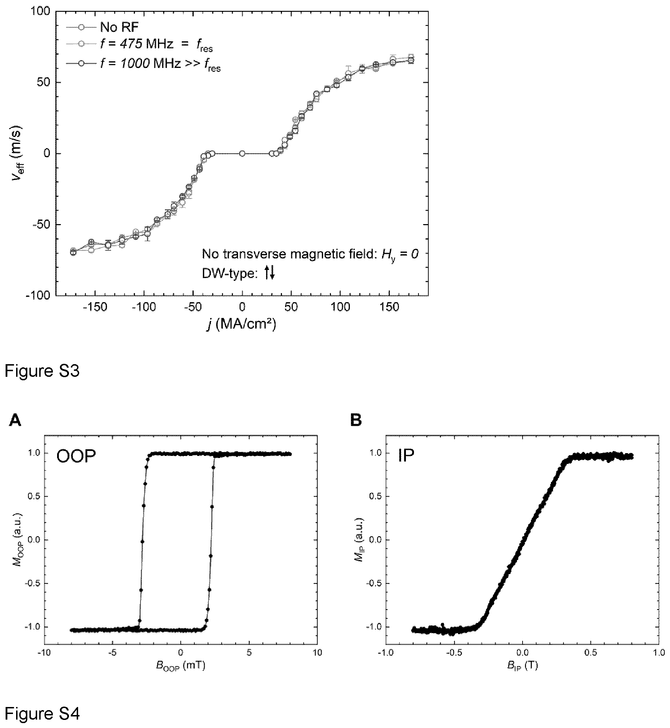

Figure 3: Current-induced DW displacement $d_p^\pm$ in the presence of a resonant RF-field. (A-C) Current-induced DWM with $t_{\text{pulse}}$ = 10 ns in the presence of $H_y$ and RF-fields. (A) $d_p^\pm$ vs. $j_p$ for $H_y$ = 18 mT. RF-powers $P_{RF}^{out} (f = 475 \text{ MHz}) = -12.7 \text{ dBm}$ and $P_{RF}^{out} (f = 1.0\,\text{GHz}) = -3.2$ dBm transmit the CPW. (B) $d_p^\pm$ vs. $H_y$ at $j_p$ = 108 MA/cm² and $P_{RF}^{out} = 0.7$ dBm in (same in B-C). The filled (open) symbols in (B), (C), (E) represent the displacement for positive (negative) current pulses $d_p^+ (d_p^-)$. (C) $d_p^\pm$ vs. frequency. Small arrows in (B) indicate the the applied $H_y$ fields. At resonance, the DW self-propels along +x so that $d_p^+$ diverges and $d_p^-$ is set to zero. (D-F) DWM in the presence of an $H_x$ field and RF-fields. Current pulses with $t_{\text{pulse}}$ = 5 ns are applied at the beginning of a microwave burst. (D) $d_p^\pm$ vs. $j_p$ for $H_x$= -12 mT for $t_{\text{burst}}$ = 5 µs. In (D-E), a microwave power $P_{RF}^{in} = 21.6 \text{ dBm}$ is applied at all frequencies. This corresponds to $P_{RF}^{out} (f = 450$ MHz) ≈ -2 dBm being transmitted. $d_p^\pm$ vs. $H_x$ at $j_p$ = 172 MA/cm² and $t_{\text{burst}}$ = 1 µs. (F) $d_p^\pm$ vs. frequency at $H_x$ = -12 mT and $j_p$ = 172 MA/cm². RF bursts with $t_{\text{burst}}$ = 5 µs and a transmitted power of $P_{RF}^{out} = -2.2 \text{ dBm}$ were used. The results for an up-down DW are shown in all figures.

Figure 4: Self-sustained domain wall propagation. (A) Sustained domain wall motion by a resonant (f = 450 MHz) microwave burst after an initial current pulse trigger. The bursting time indicates the duration of microwave application after an initial trigger pulse with $j_p$ = 172 MA/cm² and $t_{\text{pulse}}$ = 5 ns. The DW displacement increases linearly as shown by the linear fit. (B) The dependence of the RF-driven DW displacement on the width of the initial current pulse trigger is shown. Resonant microwaves with bursting times $t_{burst}$ = 1.0, 2.5 and 5.0 μs are applied. At low pulse widths, no RF-driven DWM is triggered whereas the additional RF-induced displacement saturates at $t_{pulse}$ > 5 ns. The burst time determines the magnitude of the RF-induced displacement. In (A-B), a longitudinal magnetic field $H_x$ = 12 mT was applied and the microwave power

$$P_{RF}^{out} \approx -2 \text{ dBm}$$ transmits the CPW.

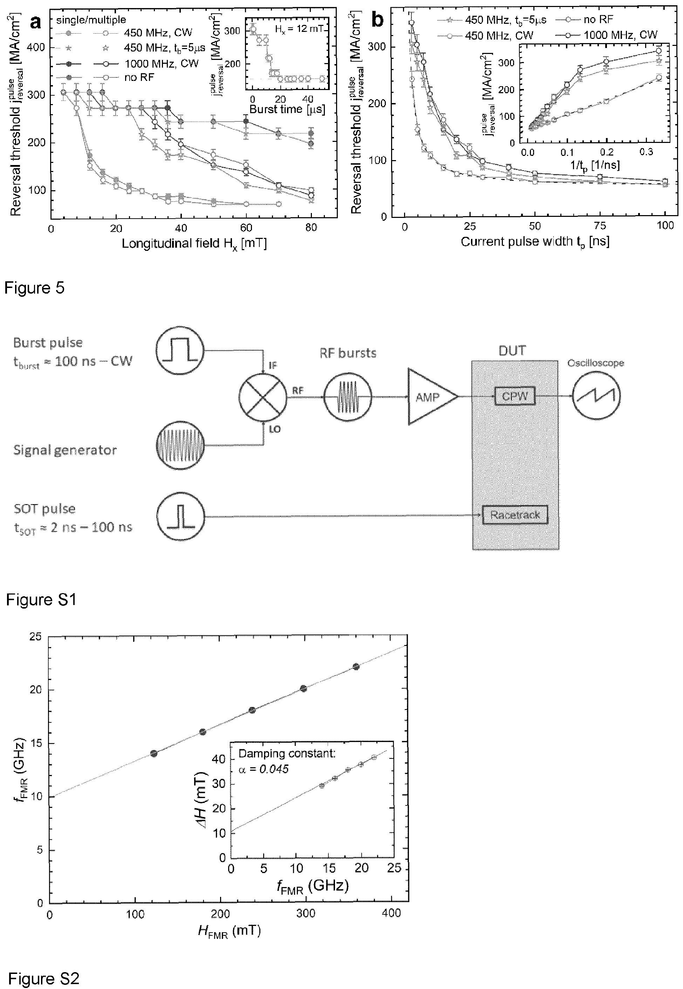

Fig. 5. Threshold current densities for current-induced magnetization reversal in the presence of additional resonant and off-resonant microwave fields. The applied microwave powers are identical to fig. 3D-E. The required current densities are shown to achieve magnetization switching by using either one or multiple consecutive current pulses (filled or open symbols) with a wait time of 100 ms. (a) Dependence of the switching threshold on the longitudinal magnetic field $H_x$ using current pulses with $t_p$ = 5 ns. The inset shows how the switching threshold gradually reduces with increasing bursting time and remains constant for $t_{burst} \geq 20$ μs. (b) Current pulse width dependence of the switching threshold. An inverse scaling $j_{reversal} \sim 1/t_p$ over the complete measurement range is only seen for the continuous-wave application of 450 MHz. This is more clearly seen in the inset depicting $j_{switching}$ as a function of the inverse pulse time $1/t_p$.

Fig. S1. Schematic of electronic measurement setup for bursted RF

Fig. S2. Dependence of the ferromagnetic resonance (FMR) frequency on the static out-of-plane field. The gyromagnetic ratio $\gamma$ and the zero-field frequency $f_0$ was extracted from a linear fit $f_{FMR} = f_0 + \gamma \cdot H_{OOP}$. The linewidth analysis (inset) reveals the inhomogeneous broadening and the damping constant $\alpha$.

Fig. S3. Domain wall velocity vs. current density in zero magnetic field. The application of neither resonant nor off-resonant microwave fields yield a significant change in the velocity. The applied microwave powers are identical to fig. 3A with

$$P_{RF}^{out} \text{ (f = 475 MHz)} = -12.7 \text{ dBm and}$$

$$P_{RF}^{out} \text{ (f = 1.0 GHz)} = -3.2 \text{ dBm}$$ transmitting through the CPW.

Fig. S4. Vibrating-sample magnetometry (VSM) measurements of the out-of-plane (OOP) magnetization in an OOP magnetic field (A) and of the in-plane (IP) magnetization in an IP magnetic field (B). The measurements were performed on an 8600 Series VSM by Lake Shore Cryotronics. We define the anisotropy field $H_K$ as the field where the extrapolated linear slope at lower fields crosses the magnetization plateau at higher fields.

Definition of terms

Throughout this Application the below listed terms shall have the following meaning:

- *Microwave, Radiofrequency, RF*
  These terms are used synonymously and refer to electromagnetic signals in the frequency range from MHz to GHz.
- *Domain wall or DW precession*

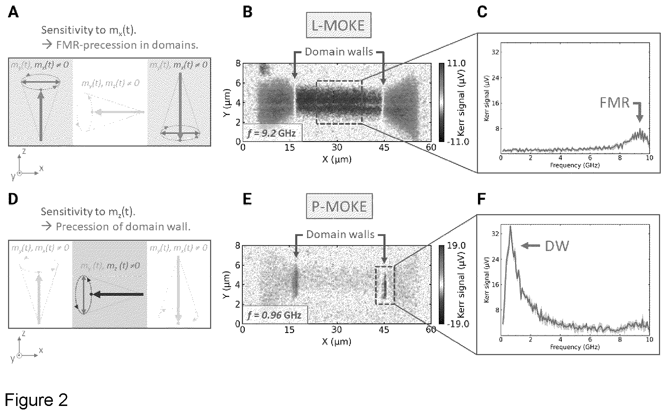

  A domain wall precession takes place when the local magnetization at the domain wall position precesses around its equilibrium orientation, i.e. the static orientation in the absence of any microwave fields. The ellipticity of this precession, i.e. the ratio of the precession amplitudes along the two axes perpendicular to the equilibrium axis, can vary depending on the geometry of the thin film and device as well as the magnetic properties. This DW precession may be accompanied by a DW oscillation, i.e. a back-and-forth movement of the center of the DW. This DW precession takes place at the "DW resonance frequency" which we denote as the frequency of the most efficient excitation of the DW precession in an RF-field. The width of the resonance, e.g. the full-width-half-maximum of the resonance peak, determines the frequency range where the DW precession can be reasonably well excited (see e.g. Fig. 2F, 3C, 3F).
  The DW resonance frequency can vary depending on external parameters such as magnetic fields and on intrinsic parameters such as the magnetic properties of the film and the shape of the device. Feasible ranges of DW resonance frequencies are:

  - (a) 10 MHz to 10 GHz (generic),
  - (b) 100 MHz to 3 GHz (preferred range),
  - (c) 200 MHz to 1.2 GHz (more preferred range).

- *Sustained motion (of a magnetic domain wall)*
  The presence of a static, longitudinal magnetic field and a resonant, transverse RF-field enables the sustained motion of a DW. In this configuration, an electrical current pulse that is applied to the magnetic conduit first induces a DW displacement by SOT. Afterwards, the presence of the resonant RF-field avoids the stopping of the DW immediately after the end of the electrical current pulse. Instead, the DW maintains a small velocity along the initial propagation direction. This kind of maintained motion after the end of the electrical current pulse is called "sustained motion of a magnetic domain wall".

- *Enhanced domain wall motion*
  The above defined "sustained motion of a DW', enhances the DW displacement per current pulse $d_p$. This enhanced DW displacement is symmetric, i.e. applies equally to both current pulse polarities. The degree of enhancement can be tuned by the bursting time. E.g., within the non-limiting examples of the present invention, the maximum observed enhancement increased $d_p$ from 0.59 $\mu$m/pulse (no RF) to 7.99 $\mu$m/pulse (resonant RF with $t_{burst}$ = 15 $\mu$s). Thus, the accessible "enhancement in DW motion" in this example ranges from 0 to 1250% in displacement.

- *Self-propulsion or self-propelling (of a magnetic domain wall)*
  In the presence of a transverse, static magnetic field and a transverse, resonant RF-field the DW moves in a defined direction without the need of an electrical DC current. This phenomenon is called "self-propulsion" or "self-propelling" and the DW is "self-propelling". The directionality of the self-propulsion is solely determined by the polarity of the static, transverse magnetic field. The DW displacement during self-propulsion scales with the bursting time of the RF-fields.

- *Lowering of the electrical current density for reduced Joule heating*
  As mentioned above, during self-propulsion of the DW, no electrical DC current needs to be passed through the magnetic conduit to move the DW. This avoids a DC-current induced Joule heating in the conduit by 100%.

- *Racetrack memory (RTM)*
  RTM is a concept that uses one or more movable magnetic DWs as magnetic shift registers to achieve non-volatile and high-density data storage. The read- and write operations are typically achieved through one or multiple ports such as magnetic tunnel junctions (MTJs), Oersted-field lines or alternative means.

- *Magnetic relaxation / Gilbert damping / inertia*
  Magnetization dynamics are damped over time, which is called "magnetic relaxation" (also called "magnetic damping"). The Landau-Lifshitz-Gilbert differential equation that governs the magnetization dynamics includes a damping parameter $\alpha$ (alpha) to quantify the strength of this relaxation. Typical damping parameter ranges are:

  - (a) 0.1 to $5 \cdot 10\text{-}5$ (generic),
  - (b) 0.1 to $5 \cdot 10\text{-}3$ (preferred range),
  - (c) 0.05 to 0.01 (more preferred range).

- *Energy required for SOT-switching*
  The energy required for SOT switching ranges approximately from 300 pJ to 5.7 nJ. However, it must be taken into account that the measured devices in the results shown here are micron-sized conduits in order to be able to optically measure them. Commercial downscaling to few tens of nanometers, impedance matching of device and external circuitry as well as the tuning of material parameters will enable typical switching energies between 10 fJ and several pJ.

- *Typical current density and current pulse width for SOT switching*
  For the data shown in Fig. 5, the typical current densities approximately range from 340 MA/cm$^2$ to 70 MA/cm$^2$ and the current pulse width ranges from 3 ns to 100 ns. As mentioned above, commercially optimized and nano-scaled devices will also allow for a better performance regarding $j_{switching}$ and $t_{pulse}$. A switching current-density down to 40 MA/cm$^2$ with current pulse widths of 500 ps is technologically possible.

<u>Detailed Description of the Invention</u>

**Resonant excitation of a domain wall precession**

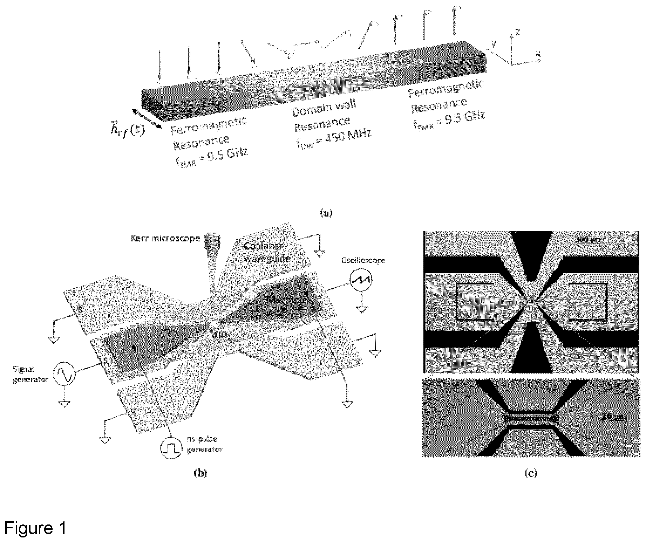

The coupling between a high frequency magnetic field and a single chiral DW is achieved by integrating a co-planar wave-guide (CPW) to the magnetic conduits with perpendicular magnetic anisotropy (Fig. 1B) - where the dynamics of chiral Néel DWs are investigated. Radio-frequency (RF) current through the CPW generates an RF-magnetic field transverse to the magnetic conduit. Furthermore, the capacitive (and inductive) coupling between CPW and magnetic conduit induces an RF-current in the conduit. In order to directly visualize the localized resonance from the chiral Néel domain wall, we use the Super-Nyquist sampling magneto-optical Kerr microscopy. To conduct the experiment, we carefully initialize two domain walls (with an up-down (down-up) domain configuration on the left (right) side of the magnetic conduit) and generate RF-fields with the CPW.

With the longitudinal configuration of the magneto-optical Kerr effect (L-MOKE) set-up, we probe the dynamic x-component, $m_x(t)$, of the magnetization precession in the magnetic conduit. When exciting the FMR mode in the uniformly out-of-plane magnetized magnetic domains, the magnetization precesses around the z-axis with a significant x-component $m_x(t)$ (see Fig. 2A). This enables us to detect the FMR in the domains with uniform perpendicular magnetization using L-MOKE. Figure 2B shows the clear presence of the uniform FMR mode at $f_{RF}$ = 9.20 GHz in the up and down domains while the DW gives zero signal. As expected, the FMR precession exhibits a sign change (180° phase jump) on either side of any DW due to the opposite static magnetization in the up- and down-domains, respectively. The L-MOKE frequency scan from 160 MHz to 10 GHz in Fig. 2C clearly shows the FMR response at approximately 9.5 GHz.

Note that, for comparison, the extrapolated zero-field FMR frequency of the un-patterned magnetic films measured with a conventional FMR set-up lies at 9.91 ± 0.01 GHz with a resonance field linewidth of $\Delta H = 10.8 \pm 1.4$ mT that corresponds to a frequency linewidth

$$\Delta f = \frac{\partial f_{FMR}}{\partial H} \Delta H = 0.37 \pm 0.05 \text{ GHz} \quad \text{(see fig. S2).}$$

The magnetization within the Néel domain wall rotates in the x-z-plane such that the magnetization at the center of the DW lies along or opposite the x-axis depending on the chirality of the wall. In our system, we have a left-handed chirality. A precession of this wall moment results in a periodic z-component of magnetization $m_z(t)$ (see Fig. 2D). Different from the previous L-MOKE configuration, the perpendicular MOKE (P-MOKE) configuration is highly sensitive to this $m(t)$ variation. Indeed, for the P-MOKE map, we distinctively observe a strong, localized response only at the positions at which DWs are placed. We find $f_{RF} = 0.92$ GHz as shown in Fig. 2E. Thus, we ascribe the two resonances to the two domain walls themselves. The phase-shift between the two DW resonances can be explained by the opposite orientation of the in-plane magnetization of the chiral walls with up-down or down-up domain configuration. The excitation frequency-dependence of this local domain wall precession in Fig. 2F exhibits a pronounced maximum around 700 MHz, which is significantly, lower than the FMR mode ($\approx 9.5$ GHz). The asymmetric DW resonance shape in Fig. 2F can be accounted for by a superposition of numerous standing spin wave modes along the width of the magnetic conduit. It seems highly unlikely that the asymmetry is caused by a hybridization of the DW and FMR modes since the band of the available forward-volume spin-waves in the uniform domains has no overlap with the low-frequency DW mode. The weak signal at the FMR frequency in the P-MOKE scan represents a FMR background that is independent of the DW and is also present in the uniform domains. Our experiments clearly visualize that the uniform domains and the chiral Néel domain walls exhibit distinct precession dynamics where the resonance frequency significantly decreases at the domain wall as illustrated in Fig. 1A.

**Microwave-induced self-propulsion of a domain wall**

We now show how the resonant DW excitation affects the DW motion. For this, we measure the current-induced DWM in the presence of continuous microwave magnetic fields. Note that these results are presented both as the DW displacement per current pulse $d_p$ as well as the effective velocity deduced from this current pulse length $t_{pulse}$. We do this so as to disentangle the consequences of microwaves and current pulses because, as we will show later, the DW may move significantly after the end of the current pulse.

Due to symmetry considerations, we do not expect an RF-field in a uniform DW energy landscape to have any averaged impact on the DWM, as shown in fig. S3. Nevertheless, we can externally modify the DW energy landscape using a static magnetic field. A transverse magnetic field $H_y$ is applied that induces a directionality to the DW propagation (see Fig. 3A for the coordinate of the system). This makes the current-induced DWM asymmetric, i.e. the DW displacement for a positive current-density, $d_p^+$, and a negative one, $d_p^-$, are not equal. If $H_y$ is positive, $d_p^+ > |d_p^-|$ and vice versa. Such asymmetric $d_p^\pm(j, H_y \neq 0)$ curves in the presence of a weak $H_y$ field of 18 mT are shown in Fig. 3A (j denotes the electrical current-density of the pulse). When a resonant RF-field (f = 475 MHz) is applied we observe a dramatic enhancement of the asymmetry in the DW propagation. The threshold for DWM at a positive current-density, $j_{th}^+$, is further lowered while the one at a negative current-density, $|j_{th}^-|$, is further increased. In addition, the maximum $d_p^+$ is increased from 0.65 μm/pulse (no RF) to 0.88 μm/pulse (f = 475 MHz). The resonant microwaves appear to create an additional torque on the DW in the preferential direction of motion. Note that this preferential direction reverses when $H_y$ is reversed. In the absence of a preferential direction, i.e. at $H_y = 0$, this torque vanishes due to symmetry, as shown in fig. S3. Note that for f = 475 MHz, the microwave power

$$P_{RF}^{out} = -12.7 \text{ dBm}$$ transmitting the CPW amounts to a peak microwave field amplitude, $h_{RF} = 0.18$ mT. For the off-resonant case at f = 1.0 GHz, despite a 10 dB increase in RF-power (corresponding to $h_{RF} = 0.54$ mT), no microwave-induced torque is visible.

In order to further understand the role of the $H_y$ field on this microwave-induced torque, the dependence of the current-induced DWM on $H_y$ is shown in Fig. 3B, without and with a microwave field at frequencies below, at, and above the resonance. For simplicity, we define

$$\Delta d_p = d_p^+ - |d_p^-|$$ as the difference in displacement for a positive and a negative current pulse. In the absence of a resonant RF-field, $\Delta d_p$ increases slowly with $H_y$. However, a resonant microwave field dramatically increases the asymmetry $\Delta d_p$ at low $H_y$, so that, at positive fields, $d_p^+$ reaches significantly higher values than in the absence of RF-fields. The maximum displacement reaches a peak value of $d_p^+ = 1.97$ μm/pulse ($|d_p^-| = 1.95$ μm/pulse) at $H_y = 18$ mT ($H_y = -20$ mT), respectively, which is more than 3 times higher than at off-resonance. $|d_p^\pm|$ then decreases and approaches the off-resonant curve at high field ($|H_y| \sim 70$ mT).

A possible explanation for the emergence of a peak in the field scan in Fig. 3B is the trade-off between the asymmetry of DWM and the coupling of the DW magnetization $\vec{M}_{DW}$ with the microwave field $\vec{h}_{RF}$. As shown in the inset of Fig. 3B, $H_y$ tilts $\vec{M}_{DW}$ in the plane by the angle $\Phi$ and this tilt gradually induces the asymmetry of the DWM. At the same time the coupling between $\vec{M}_{DW}$ and $\vec{h}_{RF}$ scales with $\cos(\Phi)$ and decreases with $H_y$. A unidirectional torque on the DW only occurs for significant contributions of both DWM asymmetry and RF-coupling. Hence, there is no RF-induced torque for $H_y = 0$ since the DWM is still symmetric. In contrast, a finite $H_y$ provides asymmetry and enables unidirectional motion of the wall. At high $H_y$, despite the highly asymmetric DWM, the coupling between $\vec{M}_{DW}$ and $\vec{h}_{RF}$ reduces and the efficiency of automation decreases.

We further measured the frequency-dependence of this unidirectional DW displacement. Fig. 3C shows that $|d_p^{\pm}|$ is clearly unaffected by the microwaves at low and high frequencies. When approaching a range of resonant frequencies that lies between 400 MHz to 550 MHz, the unidirectional DW displacement sets in, i.e. $d_p^{+}$ increases and $|d_p^{-}|$ decreases. The fact that this resonant region slightly differs from the peak frequency ($\approx$ 700 MHz) obtained from the SNS-MOKE in Fig. 2F is accounted for by the low frequency resolution of the SNS-MOKE measurement. Remarkably, for excitation frequencies within the range between 400 MHz to 550 MHz, the DW is driven without current pulses but solely due to the resonant microwave field in the presence of a static field $H_y$.

We dub this motion self-propulsion or automotion of the DW. As before, the polarity of $H_y$ defines the directionality of this automotion, i.e. for $H_y > 0$ ($H_y < 0$) the DW moves along the positive (negative) x-direction. Note that the applied RF-power determines the strength of the automotion. For weak powers (e.g. $P_{RF}^{in} = 7\ \text{dBm}$), only an enhanced asymmetry in the current-induced DWM is visible while a higher RF-power (e.g. $P_{RF}^{in} \geq$ 12 dBm) allows the automotion to overcome pinning points so that the DW visibly moves over micron distances without an electrical current. The frequency-dependency in Fig. 3C was each measured at a transverse field of 18 mT and 50 mT. Interestingly, we do not see a significant $H_y$-induced shift of the resonance region. However, we observe that the automotion efficiency at the resonance is highest at $H_y = 18$ mT and decreases at $H_y = 50$ mT. For instance, at f = 400 MHz, the automotion at $H_y = 18$ mT drags the DW along the entire racetrack for more than 30 $\mu$m without pinning whereas at $H_y = 50$ mT the maximum automotion distance between two pinning points is approximately 6.4 $\mu$m. This agrees well with our previous observation and explanation of the marked maximum of $d_p^{+}$ at $H_y = 18$ mT in Fig. 3B. Note that for large fields such as $H_y = 50$ mT, we expect the DW magnetization to be almost parallel to the RF-field. This allows parametric excitation at twice the frequency of the DW resonance above a threshold driving amplitude. However, due to the small ellipticity of the precession this effect is strongly suppressed compared to in-plane magnetized ferromagnets. In line with this expectation, no sign of such a parametric excitation at twice the frequency is observed in Fig. 3C for $H_y = 50$ mT.

We now quantify the DW velocity during the microwave-induced self-propulsion, i.e. without current pulses. We therefore track the gradual DWM upon the application of subsequent RF-bursts with duration $t_{burst} = 100$ ns to the the device. Using this method, we measured the speed of a self-propelling DW as $v^{+} = 1.85$ m/s and $v^{-} = 2.04$ m/s at $f = 450$ MHz, $H^y = \pm24$ mT and $P_{RF}^{out} = 5.6\ \text{dBm}$. To put our results into perspective, we note that the automotion of magnetic bubbles with a specific magnetic configuration was accomplished many decades ago by Argyle et al. by using a pulsed $h_z(t)$ field (B. E. Argyle, S. Maekawa, P. Dekker, J. C. Slonczewski, Gradientless propulsion and state switching of bubble domains. AIP Conf. Proc. (1976)). In contrast, our work reports the self-propulsion of straight DWs that is independent on the DW configuration (i.e. up-down or down-up) and requires a transverse, resonant excitation field $h_y(t)$ rather than an off-resonant bias field pulse $h_z(t)$.

**Current pulse-triggered self-sustained domain wall motion**

We now investigate the effect of the DW resonance on the current-induced DWM in a static longitudinal magnetic field $H_x$. Due to the Dzyaloshinskii-Moriya interaction (DMI) the magnetic DWs are Néel-type and have a defined rotational sense. The DMI induces an effective magnetic field $\vec{H}_{DMI}$ that points along the DW magnetization $\vec{M}_{DW}$ (see inset of Fig. 3D). $\vec{H}_{DMI}$ hence points along -x (+x) for an up-down (down-up) DW configurations. It is well established that an $\vec{H}_x$ along (opposite to) $\vec{H}_{DMI}$ will result in an increased (decreased) displacement $|d_p^{\pm}|$. Up-down and down-up DWs will hence react oppositely to $H_x$. When $\vec{H}_x$ opposes the DMI-field and exceeds its magnitude, $d_p^{\pm}$ reverse their sign, i.e. the DWs now move along the electron flow instead of the current flow. In contrast to a transverse $H_y$ field, the DWM remains symmetric in the presence of an $H_x$ field, that is $d_p^{+} = |d_p^{-}|$. Fig. 3D shows the $d_p^{\pm}(\text{j})$ measurement for an up-down DW with $H_x = -12$ mT that is applied along the $H_{DMI}$ of the DW. In the absence of RF-fields and for off-resonant RF-fields (100 MHz, 1.0 GHz) the data is similar and shows a symmetric DWM with increased speed compared to the zero-field case (open, grey symbols in Fig. 3A). Surprisingly, a resonant microwave-field at f = 450 MHz enhances the current-induced DW displacement $d_p^{\pm}$ as soon as the current-density of the pulse exceeds a certain threshold value of j ~ 137 MA/cm$^2$. Note that this enhanced DW displacement is still symmetric, i.e. $d_p^+$ and $\left| d_p^- \right|$ are almost equally increased. Differential Kerr images of these effects are given in fig. S4.

We next discuss the field-scan $d_p^\pm (H_x)$ in Fig. 3E to investigate the role of the $H_x$ in this resonant enhancement. Without resonant microwaves present, $\left| d_p^\pm \right|$ is linearly increasing with negative $H_x$ as previously described. When resonant microwaves at 450 MHz are applied, $\left| d_p^\pm \right|$ exhibits a drastic increase once the longitudinal field falls below $H_x \approx$ -8 mT. This shows that aside from the threshold in j, a threshold longitudinal field $H_x$ is required in parallel to $H_{DMI}$ to achieve the RF-enhanced DWM.

The frequency dependence of the microwave-enhanced DWM in Fig. 3F shows that the resonant enhancement of $d_p$ (the average of $d_p^\pm$) only occurs in a narrow frequency window. While $d_p \approx$ 0.59 $\mu$m/pulse holds for off-resonant frequencies, a peak value of $|d_p|$ = 2.50(6) $\mu$m/pulse is achieved at f = 450 MHz. This represents an enhancement of more than 420% compared to the off-resonant excitation. This resonance is in agreement with the results in Fig. 3C. Note that in Figs. 3D-F, instead of applying a continuous wave RF-field, we used microwave mixers to send RF-bursts with the duration $t_{burst}$ of a few $\mu$s into the CPW to controllably gauge the RF-effect (see fig. S1). The timing between RF-burst and electrical current pulse through the magnetic conduit is crucial. We find that an arbitrarily long RF-signal before the current pulse has no effect on the DW. However, the burst duration after the current pulse determines how much the DW moves in a linear fashion (see Fig. 4A). This suggests that the current pulse triggers the current-induced DWM that is subsequently sustained in the presence of the microwave excitation. The linear fit in Fig. 4A yields the effective DW velocity arising from the microwave field as $v_{RF}$ = 0.41(2) m/s. Note that in addition to $t_{burst}$, the applied RF-power also effects the magnitude of the RF-induced displacement.

In order to trigger this RF-induced, sustained DWM, a sufficiently long current pulse is required. Figure 4B shows that $d_p$ starts to increase and deviate from the SOT-driven linear slope as soon as RF-bursts with $t_{pulse}$ > 3.5 ns are applied. The data further suggests a saturation of this microwave-induced displacement for $t_{pulse}$ > 5 ns where the $d_p$ scales again linearly with the applied current pulse widths. The displacement for longer $t_{burst}$ show the same $t_{pulse}$-dependence but exhibit a larger total displacement $d_{RF}$ as expected from Fig. 4A.

We finally stress that the large enhancement of the DW speed is not caused by an automatic motion of the wall as in the case of a transverse field. Aside from the presence of static $H_x$ and time-varying $h_y^{RF}$ field, a sufficiently long and high electrical current pulse is essential to initially move the DW and trigger the subsequent microwave-driven motion. This suggests that sufficient initial momentum of the DW is required to allow for its continued motion after the end of the current pulse, thereby deciding on the direction of the sustained motion. After the end of the current pulse, the resonant microwave excitation of the moving DW seems to compensate for its energy dissipation by magnetic damping, thereby sustaining its momentum.

Regarding the RF-enhanced DWM in the presence of an $H_x$ field, we have ensured that these observations are caused exclusively by the motion of a DW and not by the reversal of uniform magnetic domains. For that purpose, we first confirmed that the DW in the presence of RF-field bursts and current pulses propagates monotonously with consecutive current pulses and does not exhibit any abrupt reversal of large parts of the racetrack. Second, a uniformly magnetized magnetic conduit shows no reversal for the respective current densities, static fields and RF-powers used in Fig. 3D-F.

**Resonantly enhanced magnetization reversal**

Nevertheless, we investigated the current-induced magnetization reversal in a longitudinal $H_x$-field, caused by spin-orbit torque, in the presence of RF magnetic fields. We investigated both the threshold current density for stable magnetization reversal that only requires a single current pulse (filled symbols) and for a partial reversal that requires multiple consecutive current pulses to obtain a stable reversed domain (open symbols). The lower threshold for the partial reversal suggests the initial presence of small, unstable regions with reverse magnetization that require additional current pulses to expand into a visible stable state.

Figure 5A shows the typical decrease of the threshold current density as function of the required longitudinal field. In the case that CW RF-fields at the resonant frequency of 450 MHz are applied, a significant reduction in the reversal threshold is observed. However, the inset of Fig. 5A shows that long burst times of $t_{burst} \geq$ 20 $\mu$s are required for the maximum reduction of the switching threshold from 305 MA/cm$^2$ (no RF) to 154 MA/cm$^2$ ($t_{burst}$ = 20 $\mu$s). When applying continuous-wave (CW) RF-fields at an off-resonant frequency of 1.0 GHz instead, the threshold current density only minutely differs from the case without RF-fields.

We observe that the current densities for stable and partial reversal are very similar for resonant CW microwaves while they significantly differ otherwise. In this context, it is worth mentioning that magnetization reversal by SOT from ns-long current pulses is typically caused by DW nucleation (i.e. local magnetization reversal) and subsequent DW expansion. Moreover, our previously shown results have shown the drastic effects of a resonant RF-field on DWM. Altogether, this suggests that resonant RF-fields might facilitate the expansion of small, reversed regions into larger, stable domains. A coherent switching of the magnetization in our device seems unlikely.

In Fig. 5B, we show the dependence of this reversal on the current pulse width $t_p$. As before, the largest decrease in the threshold current density is seen for resonant CW fields while only minute changes are observed for off-resonant microwaves. Both resonant and off-resonant curves almost converge towards large pulse widths of 100 ns, where the reversal is heavily affected by thermally assisted switching. However, the reduced reversal threshold for the resonant CW excitation is very pronounced for lower pulse widths below $t_p <$ 15 ns. Interestingly, only for the resonant excitation $j_{reversal}^{pulse}$ perfectly follows a $1/t_p$ behavior throughout the whole measurement range while such a fitting can only be performed for either low or large pulse widths in all other shown cases (cf. inset of Fig. 5B).

**Conclusion**

We have visualized the microwave magnetic field-induced resonant excitation of a DW precession in magnetic conduits and, thereby, shown the strong influence of this precession on the DW motion. In particular, we have demonstrated that resonantly excited DWs exhibit current-free self-propulsion along the entire magnetic conduit, in the presence of static, transverse magnetic fields. Furthermore, this resonant excitation effectively lubricates the motion of the DWs in the presence of a static, longitudinal magnetic field so that after a triggering nanosecond-long current pulse, the DWs move over long distances of microns or more. Lastly, we show that RF magnetic fields at the DW resonance facilitate the magnetization reversal. Our discoveries significantly extend our scientific understanding of magnetic DWs and provide novel mechanisms of their manipulation. This will accelerate the development of novel spintronic devices.

In the following, the major technical applications of the present invention will be summarized, namely:

    **(A)** Enhancement of the performance and functionality of racetrack memory (RTM)
    **(B)** Enhancement of spin-torque switching in MRAM applications.

**(A) Enhancement of the performance and functionality of racetrack memory (RTM)**

A racetrack memory (e.g. US 6,834,005) proposes the use of movable magnetic domain walls to realize a shift register with one or more read and write port as a novel memory architecture. There are multiple possible realizations for such a device including (a) a single domain wall and a read/write port, (b) multiple domain walls (multi-bit) on a racetrack with one or many read/write ports, (c) one or multiple domain walls in a racetrack with one broad, elongated read port to realize analog-like data output or (d) racetracks with either combined or separate read/write ports.

The key ingredients of such an architecture towards a successful and cost-effective realization are (i) operation speed, (ii) energy efficiency, (iii) bit density and stability and (iv) read/write efficiency.

**(A.1)** A first aspect of this invention mainly aims to improve the points (i-ii) of racetrack memory but this might indirectly also allow improvements in (iii). It is proposed to do so by using the enhanced domain wall propagation that is induced by the domain wall precession. It has been shown that the excitation of the domain wall resonance (also sometimes mentioned as "resonant domain wall precession") in a static, longitudinal magnetic field yields a reduced threshold current-density for operation and an enhanced propagation distance per current pulse. This is achieved since the microwave magnetic field continuously resupplies energy to the moving domain wall, thereby accounting for energy losses due to damping. This method has the following impact on racetrack memory:

    (i) Lower current pulse energy (proportional to the squared pulse current density x pulse with) is required for same domain wall shift operation due to the enhanced domain wall displacement
    (ii) Since the domain wall precession reduces the damping of a moving domain wall, this reduces the impact of domain wall pinning at magnetic inhomogeneities or defects along the racetrack. The reduced pinning of the domain wall facilitates its precise positioning which is crucial for maintaining the stable storage of magnetic bits during the repeated shift operations of the racetrack memory.

**(A.2)** A second aspect of this invention relates to the self-propulsion of magnetic domain walls, induced by the domain wall precession in a transverse magnetic field, offers advantages to the current-induced domain wall motion or could assist the latter. A common problem of racetrack memory is the high electrical resistance of such devices. This induces a lot of Joule heating when passing current pulses through the racetrack and in turn causes (i) non-homogeneous propagation, (ii) eventual device breakdown, (iii) high energy consumption and (iv) requires the integration of efficient heat-sinks later-on in dense integrated memory circuits. Furthermore, the high resistance complicates the efficient injection of short current pulses into the racetrack due to the impedance mismatch to impedance standards of typical microwave circuitry.

Using the microwave-induced self-propulsion with separated microwave-circuitry avoid the problems of direct-current induced Joule-heating in the racetrack and mitigates the problem of impedance mismatching since the microwave conduit can be designed to have a much lower, suitable impedance than the racetrack.

As mentioned, the common racetrack operation of moving domain walls back and forth can be realized by applying a resonant microwave magnetic field and a static transverse field. This static field determines the direction of motion of the domain walls. It is thus required to reverse this static field regularly. The possible technical realizations of the setup are listed below. Furthermore, the duration of the applied microwave power determines the propagation distance. The propagation efficiency can be tuned by (a) the applied microwave frequency, (b) the microwave power, (c) the strength of the transverse magnetic field.

The possible technical realization for the required microwave conduits in **(A)** is as follows:

a) Electrically separated microwave-conduits (such as co-planar waveguides, stripline, microstrip lines, etc.) may create a high-frequency magnetic field at the magnetic racetrack. These microwave-conduits have no direct electrical connection to the remaining memory circuitry and may be spaced several nanometers or micrometers away. This approach offers advantages regarding the impedance matching of the conduit and offers to place many racetracks on top of one large microwave-conduit in order to improve its energy efficiency.

b) The microwave-circuitry may be integrated into the racetrack itself so that an electrical microwave current flows through the racetrack and directly induces a spin-torque at the injected microwave frequency. By injecting a microwave spin-current in contrast to a microwave field (cf. option (a)), this approach here might enable higher efficiency of the induced microwave spin-torques than approach (a). However, it might require additional impedance matching circuitry for good microwave-injection into the racetrack.

The possible technical realization for the required static magnetic fields is as follows:

a) A direct electrical current that is flowing through a nearby conductor (commonly dubbed as an "Oersted-line") induces a magnetic field at the position of the racetrack. Two such Oersted-lines at an angle to each other (e.g., at 90° angle) enable both a longitudinal and transverse magnetic field or any desired field direction in the x-y plane of the racetrack. The advantage of (a) is the tunability of the magnetic field strength.

b) Alternatively, a soft magnetic element can be placed near the racetrack to create a stray magnetic field that impinges the racetrack. This approach is non-volatile and energy efficient and requires energy only when switching the magnetic element. However, the field strength cannot be controlled as in (a) and is constant. The switching of the magnetic element, i.e., changing the sign of the magnetic field, could be realized by various ways: e.g., by an Oersted-line or by different current-induced spin-torques.

**(B) Enhancement of spin-torque switching in MRAM applications**

Magnetic random-access memory (MRAM) is a modern memory application for non-volatile data storage where information is encoded in the orientation of the so-called "free-layer" of a magnetic tunnel junction (MTJ). This essentially requires:

(i) Energy-efficient, deterministic and fast writing (i.e. re-orientation) of the magnetic free layer in an MTJ.
(ii) Read-out of the free-layer magnetization state by tunneling magnetoresistance (TMR). A high TMR-ratio (i.e. signal-to-noise ratio) is required for fast read-out operation.

The invention aims at improving the writing-step (i) and will refer to the terms "switching" or "reversal" in this regard. Since the switching process in MTJs typically comprises of two steps, nucleation of a magnetic domain wall and its subsequent propagation, the excitation of the domain wall resonance significantly impacts the switching process. We have shown that the excitation of the domain wall precession reduces the required electrical current density and the required current-pulse width and thus the required energy for switching (more precisely: spin-orbit torque switching). It has been shown that the domain wall displacement can be enhanced by the precession. Hence, we anticipate that also the switching speed can be enhanced. In conclusion, we propose that the excitation of a domain wall precession by microwave fields or currents might improve the energy efficiency and/or speed of the switching operation of a magnetic tunnel junction.

Regarding the technical realization of this invention, two possible approaches are proposed:

(a) Electrically separated microwave-conduits may create a high-frequency magnetic field at the magnetic element that is to be switched. These microwave-conduits have no direct electrical connection to the remaining memory circuitry and may be spaced several nanometers or micrometers away. This approach offers advantages regarding the impedance matching of the conduit and offers to place many memory cells on top of one large microwave-conduit in order to improve its energy efficiency.

(b) The microwave-circuitry may be integrated into the read/write-circuitry so that an electrical microwave current flows through the MTJ stack and induces a spin-torque at the injected microwave frequency. The feasibility of this kind of circuitry has been shown already e.g. for spin-torque nano-oscillators or spin-torque diodes but not for microwave-assisted MTJ-switching. By injecting a microwave spin-current in contrast to a microwave field (cf. option (a)), this approach here might enable higher efficiency of our proposed mechanism of enhanced switching than approach (a). However, it might require additional impedance matching circuitry for good microwave-injection into the MTJ.

In the following, more details on materials and methods used in the context and for carrying out the present invention will be described:

**Materials and Methods**

**Device fabrication and thin film preparation**

The measured devices were fabricated using a four-step lithography process: First, 5 nm Ti and 220 nm Au was deposited on a Sapphire substrate with 001-cut by ion beam deposition. Then, the CPW was patterned by a conventional negative tone photoresist (ARN4340) and etched by Argon ion milling (Scia coat 200). The gaps were subsequently filled by $AlO_x$ (in-situ ion-beam deposition). The signal line of the CPW has a width ws = 10 $\mu$m, a gap $g$ = 3 $\mu$m and a ground plane width $w_G$ = 100 $\mu$m in the center region. The dimensions laterally increase to ws = 300 $\mu$m, $g$ = 90 $\mu$m and $w_G$ = 300 $\mu$m towards the region where the wirebonds are placed (see Fig. 1C). Secondly, a lift-off technique was used to deposit an 80 nm $AlO_x$ layer using ion-beam deposition in order to electrically isolate the CPW from the racetrack. Thirdly, using photolithography for a double-layer of ARBR5480/ARP3540T (positive resist from the portfolio of the company 'Allresist GmbH'), a resist mask with undercut was formed. Then the magnetic thin films were deposited and lifted-off to form magnetic nanowire on the CPW. The magnetic thin films were grown by a home-built d.c. magnetron sputtering at an Argon pressure of 3 mTorr. The base pressure of the home-built sputtering system was below $10^{-9}$ Torr. The film structure was as follows: 20 TaN / 50 Pt / 1 Ta / 3 Co / 7 Ni / 3 Co / 30 TaN (the numbers indicate the thickness in Angstrom). Note that the Tantalum thicknesses were varied to tune the magnetic anisotropy of the film-, which is strongly dependent on Pt/Co interface. Lastly, after the deposition of the magnetic microstructures, a conventional lift-off technique was used to deposit electrical contact pads by ion-beam deposition (5 nm Ti / 60 nm Au). The static and dynamic magnetic properties of the magnetic films were measured using vibrating-sample magnetometry (VSM) and FMR, respectively (see Fig. S2). Note that these measurements were performed with un-patterned 5x5 $mm^2$ samples at room temperature. A home-built FMR setup was used to measure the resonant frequencies, linewidths and damping constants of thin magnetic films down to 1.3 nm. In order to perform the measurement, the sample was placed on top of a CPW (Rosenberger GmbH). Passing microwaves with gigahertz frequencies through the CPW generates a high-frequency magnetic field in the plane of the magnet. This excitation field is perpendicular to a static field of an electromagnet that is oriented along the easy axis of the magnet. The amplitude of the static field is weakly modulated and hence modulates the microwave absorption of the sample at the ferromagnetic resonance. After rectification of the microwave signal, it is detected with a lock-in amplifier.

**Domain wall motion measurement**

In order to investigate DWM under microwave excitation, static Kerr microscopy in P-MOKE geometry was used. In particular, differential mode imaging, i.e. by subtracting a background image, yields a significantly enhanced contrast for any motion of domain walls. For the measurements of DWM, we first isolated a single DW in the microwire. Current-induced DWM is induced by applying a series of current pulses with current density j and widths $t_{pulse}$ of typically 5 ns or 10 ns through the racetrack device. Note that the SOT is the major source for current-induced DWM in our system and induces a DW motion opposite to the electron flow. The DW velocity is then determined from the wall displacement vs. the number of injected pulses. This procedure is repeated several times to obtain a reasonable mean value and statistical error. This method is still used for current-induced DWM in the presence of microwave magnetic fields. However, in addition to the determination of the effective current-induced DW velocity that is calculated based on the ns-long pulse widths, we also indicate the DW displacement per current pulse. This enables to disentangle effects from ns-long current pulses and the typically $\mu$s-long or continuous microwaves. Note that the typical velocity determination is only well-defined if electrical current pulses are required to initiate DWM. When a DW exhibits spontaneous self-propulsion over significant distances without extrinsic pinning, a solely current-induced DW velocity cannot be determined. In this case, microwave bursts need to be employed to obtain the velocity of solely RF-driven self-propulsion of the wall (without any electrical current).

**Typical v(Hx, Hy) dependence of the current-induced domain wall motion**

The modification of the current-induced DWM in presence of a static transverse ($H_y$) or longitudinal ($H_x$) field has been extensively studied in the past (K.-S. Ryu, L. Thomas, S.-H. Yang, S. Parkin, Chiral spin torque at magnetic domain walls. Nat. Nanotechnol. 8 (7), 527-533 (2013)). A static transverse $H_y$ field induces asymmetry to the DWM, i.e. |v+| $\neq$ |v-|. The directionality of DWM manifests in a mostly unchanged (or slightly enhanced) speed along the favored direction and a linearly reduced speed in the opposite direction. The favored direction is defined by the polarity of $H_y$, e.g. a positive $H_y$-field favors a motion along +x and vice versa. In contrast, a static longitudinal magnetic field $H_x$ results in a symmetric modification of the DWM, i.e. the DW moves symmetrically ($|v+|$ = $|v-|$) but its absolute speed is enhanced (reduced) if $H_x$ points along (opposite) the effective DMI-field $H_{DMI}$ of the chiral Néel DW. Since an up-down wall has a negative $H_{DMI}$, the DW speed linearly increases when $H_x$ is negative and parallel to $H_{DMI}$. When $H_x$ is opposing $H_{DMI}$, the speed linearly decreases and eventually becomes zero for $H_x = -H_{DMI}$. The DW moves again for $H_x > -H_{DMI}$ but the velocities reverse sign, i.e. the DW now moves along the electron flow instead of the current flow. Note that down-up wall configuration has the opposite $H_{DMI}$ field so that $v_{up-down}(H_x) = v_{down-up}(-H_x)$.

Microwave setup

The Keysight signal generator N5183B MXG and the MiniCircuits amplifier ZVA-0.5W303G+ are used to inject a high-frequency signal into the CPW below the racetrack. This generates a high-frequency magnetic field at the racetrack which is perpendicular to the direction of the applied current pulses. The Biot-Savart law enables the analytical conversion of the transmitted microwave power through the CPW into the generated microwave field amplitude $h_{RF}$ at the magnetic conduit. The transmitted microwave signal is monitored by a Tektronix MSO64 oscilloscope. In order to precisely tune the effect of the radio-frequency field on the DWM, we applied RF-bursts instead of continuous-wave RF. For this, we used a microwave mixer M1-0012LQP from Marki Microwave and a burst pulse generator. The burst was then amplified, sent into the CPW and the transmitted burst was detected by the oscilloscope. If required, an additional SOT current pulse was sent into the racetrack with adjustable timing with respect to the RF-bursts. In most cases, the SOT pulse was being sent through the magnetic conduit a few ns after the beginning of the RF burst. Note that due to the timing uncertainty of a few ns between SOT pulse and RF burst, we did not investigate the timing of the SOT pulse with respect to the phase of the RF-signal.

**Capacitive and inductive coupling between magnetic conduit and CPW**

We use an electrical microwave current flowing through a co-planar wave-guide to generate a microwave magnetic field h(t) at the magnetic conduit. Since conduit and CPW are thin metallic sheets that are separated by 80 nm of $AlO_x$, we expect a strong capacitive (and a weaker inductive) coupling. This will result in microwave electrical currents flowing in the thin film multilayers that affects the magnetic DW through spin-orbit and spin-transfer torques as well as Oersted fields. We estimate the capacitively induced RF-currents by comparing the dc impedance of conduit and CPW as following, $I_{CPW}/I_{conduit} = R_{CPW}/R_{conduit}$. We conclude that $I_{conduit} \approx 0.017 \cdot I_{CPW}$. Assuming an ideal loss-free 50 $\Omega$ impedance-matched CPW for $P_{in} = 23$ dBm, $I_{CPW} = 63$ mA, this results $I_{conduit} = 1$ mA. This corresponds to a current density of $j_{conduit} = 7.6$ MA/cm$^2$, which is significantly below the threshold current density for current induced DWM ($j_{th} \approx 40$ MA/cm$^2$) in our device.

**Super-Nyquist sampling magneto-optical Kerr microscopy**

To investigate the magnetic response at the DWs and adjacent uniform domains, we utilized a variant of time-resolved magneto-optical Kerr (TR-MOKE) microscopy that we refer to as Super Nyquist sampling magneto-optical Kerr microscopy. In our approach, a RF-current at GHz frequencies passing through a CPW generates an AC magnetic field, which excites magnetization dynamics within the micro-structured magnetic sample. As a probe, we employed a short-pulsed laser system operating at 515 nm with a repetition frequency of 80 MHz. By means of a high numerical aperture microscope objective the laser beam is focused to a diffraction limited spot size of $\approx$300nm. Thus, we obtain a signal, which corresponds to a change of the light's polarization state under reflection via the magneto-optical Kerr effect occurring within the diffraction limited area of the laser spot. In contrast to conventional TR-MOKE experiments, our approach does not require additional external modulation techniques. To overcome this, we stabilize the laser's repetition rate, the frequency generator as well as the Lock-in amplifier to an external master clock. This allows for the direct demodulation at alias frequency components $|n \cdot f_{rep} - f_{RF}|$, where n is an integer number representing the comb lines of the frequency comb of the ultra-short laser pulses. These alias frequencies originate from an under-sampling of GHz dynamics with the 80 MHz sampling frequency of the laser pulses. However, since all frequency components are stabilized to the external clock, the exact position of the alias frequency is predetermined and can be used for demodulation, without the need of any additional modulation. This case of under-sampling allows to reconstruct the amplitude and phase information at arbitrary frequencies. In this work we distinguish between two different MOKE geometries: (1) For out-of-plane magnetized samples, as demonstrated in this work, the dynamic P-MOKE component only becomes visible in the region of a domain wall. The static magnetization at the DW is rotated towards the in-plane direction and thus the precessional dynamics in the DW will have a non-zero z-component, which are thus accessible with P-MOKE. (2) In order to image the precessional motion of an out-of-plane magnetized film, one needs to access the dynamic longitudinal component of the magnetization, which points along x-direction (i.e. along the magnetic wire). For this, we block half of the incoming beam and cut half of the wave-vector spectrum provided by the microscope objective. As a consequence of this, the longitudinal components of the Kerr rotation will not average to zero anymore and can be obtained by means of lock-in detection. In such a geometry, the L-MOKE is solely sensitive to the dynamics in the domains, where the magnetization points out-of-plane (OOP) and the precession has x- and y-components, while it cannot access the DW where the magnetization statically points along x-direction, while its precession will only provide a dynamic y- and z-component.

The following claims are part of the description.

## Claims

1. A method for improving operational speed and energy efficiency of a racetrack memory (RTM) by using enhanced domain wall propagation induced by domain wall precession.

2. The method of claim 1 for lowering current pulse energy, for reducing the damping of a moving domain wall of an RTM and for resupplying energy to the moving domain wall of an RTM.

3. A method for reducing Joule heating of the magnetic conduit of an RTM device by self-propulsion of magnetic domain walls induced by domain wall precession.

4. The method of claim 3, wherein self-propulsion of domain walls is microwave-induced self- propulsion.

5. The method of claim 4 for reducing Joule heating of the magnetic conduit of an RTM device.

6. The use of domain wall precession for enhancing domain wall propagation and inducing self-propulsion of magnetic domain walls in an RTM device.

7. A method for reducing the required electrical energy for spin-orbit torque switching of a magnetic random-access memory (MRAM) device by excitation of the domain wall resonance.

8. The method of claim 7 for improving the writing step of a MRAM device.

9. The method of claim 7 for reducing the required electrical current density and the required current-pulse width of MRAM device.

10. The use of excitation of domain wall resonance for reducing the required electrical energy for spin-orbit torque switching of a MRAM device.

(a)

(b)

(c)

Figure 1

Figure 2

Figure 3

Figure 4

Figure 5

Figure S1

Figure S2

Figure S3

Figure S4

Europäisches
Patentamt

European
Patent Office

Office européen
des brevets

## EUROPEAN SEARCH REPORT

**Application Number**

EP 25 15 0712

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHEN Z Y ET AL: "Microwave fields driven domain wall motions in antiferromagnetic nanowires", NEW JOURNAL OF PHYSICS, vol. 20, no. 6, 5 June 2018 (2018-06-05), pages 1-8, XP093283877, GB ISSN: 1367-2630, DOI: 10.1088/1367-2630/aac68e * abstract; page 1, paragraph 2 - page 8, paragraph 1; figures 1-5 * | 1-6 | INV. G11C11/16 G11C19/08 |
| A | US 2019/378973 A1 (CHEN CHING-TZU [US] ET AL) 12 December 2019 (2019-12-12) * paragraphs [0028], [0063] - [0076]; figures 10, 15 * | 1-6 | |
| Y | MORIYAMA T ET AL: "Microwave-assisted magnetization switching of Ni80Fe20 in magnetic tunnel junctions", APPLIED PHYSICS LETTERS, AMERICAN INSTITUTE OF PHYSICS, 2 HUNTINGTON QUADRANGLE, MELVILLE, NY 11747, vol. 90, no. 15, 12 April 2007 (2007-04-12), pages 1-3, XP012094095, ISSN: 0003-6951, DOI: 10.1063/1.2720746 * page 1, left-hand column, paragraph 1 - page 2, right-hand column, paragraph 1; figures 1,2 * * page 2, right-hand column, last paragraph - page 3, left-hand column, paragraph 1; figure 3 * * page 3, right-hand column, paragraph 2 * | 7-10 | TECHNICAL FIELDS SEARCHED (IPC) G11C |

-/--

The present search report has been drawn up for all claims

| Place of search | Date of completion of the search | Examiner |
|---|---|---|
| The Hague | 8 September 2025 | Colling, Pierre |

EPO FORM 1503 03.82 (P04C01)

page 1 of 2

Europäisches
Patentamt
European
Patent Office
Office européen
des brevets

# EUROPEAN SEARCH REPORT

**Application Number**

EP 25 15 0712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/223784 A1 (HE LIANG [CN] ET AL) 14 July 2022 (2022-07-14) * line 9, paragraph 27 - line 13; figures 2A, 2B * | 7-10 | |
| A | BIVAS RANA ET AL: "Applications of Nanomagnets as Dynamical Systems", ARXIV.ORG, CORNELL UNIVERSITY LIBRARY, 201 OLIN LIBRARY CORNELL UNIVERSITY ITHACA, NY 14853, 24 February 2021 (2021-02-24), pages 1-110, XP081892108, * page 20, paragraph 1 - page 21, paragraph 1 * | 1-6 | |
| A | WANG XI-GUANG ET AL: "Current-driven domain wall motion enhanced by the microwave field", JOURNAL OF APPLIED PHYSICS, AMERICAN INSTITUTE OF PHYSICS, 2 HUNTINGTON QUADRANGLE, MELVILLE, NY 11747, vol. 116, no. 2, 10 July 2014 (2014-07-10) , pages 1-5, XP012187846, ISSN: 0021-8979, DOI: 10.1063/1.4887801 [retrieved on 1901-01-01] * page 1, left-hand column, paragraph 2 - page 5, left-hand column, paragraph 1; figures 1-5 * | 1-6 | TECHNICAL FIELDS SEARCHED (IPC) |

The present search report has been drawn up for all claims

| Place of search | Date of completion of the search | Examiner |
|---|---|---|
| The Hague | 8 September 2025 | Colling, Pierre |

EPO FORM 1503 03.82 (P04C01)

Europäisches
Patentamt

European
Patent Office

Office européen
des brevets

**Application Number**

EP 25 15 0712

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

    see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION**
**SHEET B**

The Search Division considers that the present European patent application does not comply with the requirements of unity of invention and relates to several inventions or groups of inventions, namely:

```
    1. claims: 1-6

        racetrack memory using domain wall propagation induced by
        domain wall precession
                        ---


    2. claims: 7-10

        spin-orbit torque magnetic random-access memory device
        switching by excitation of domain wall resonance
                        ---
```

## ANNEX TO THE EUROPEAN SEARCH REPORT
## ON EUROPEAN PATENT APPLICATION NO.

EP 25 15 0712

This annex lists the patent family members relating to the patent documents cited in the above-mentioned European search report.
The members are as contained in the European Patent Office EDP file on
The European Patent Office is in no way liable for these particulars which are merely given for the purpose of information.

08-09-2025

| Patent document cited in search report | Publication date | Patent family member(s) | | Publication date |
|---|---|---|---|---|
| US 2019378973 A1 | 12-12-2019 | NONE | | |
| US 2022223784 A1 | 14-07-2022 | CN | 112582531 A | 30-03-2021 |
| | | EP | 4030495 A1 | 20-07-2022 |
| | | US | 2022223784 A1 | 14-07-2022 |
| | | WO | 2021063370 A1 | 08-04-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6834005 B

**Non-patent literature cited in the description**

- **S. S. PARKIN** ; **M. HAYASHI** ; **L. THOMAS**. Magnetic domain-wall racetrack memory.. *Science*, 2008, vol. 320 (5873), 190-194
- **Z. LUO** ; **A. HRABEC** ; **T. DAO** ; **G. SALA**. Current-driven magnetic domain-wall logic. *Nature*, 2020, vol. 579 (7798), 214-218
- **Q. SHAO et al.** Roadmap of spin-orbit torques. *IEEE Trans. Magn*, 2021, vol. 57 (7), 1-39
- **D. KUMAR** ; **T. JIN** ; **R. SBIAA** ; **M. KLÄUI** ; **S. BEDANTA**. *Domain wall memory: Physics, materials, and devices Phys. Rep.*, 2022, vol. 958, 1-35
- **G. VENKAT** ; **D. A. ALLWOOD** ; **T. J. HAYWARD**. Magnetic domain walls: types, processes and applications.. *J. Phys. D: Appl. Phys.*, 2023, vol. 57 (6), 063001
- **J.-C. JEON** ; **A. MIGLIORINI** ; **L. FISCHER** ; **J. YOON** ; **S. S. P. PARKIN**. Dynamic manipulation of chiral domain wall spacing for advanced spintronic memory and logic devices.. *ACS Nano*, 2024, vol. 18 (22), 14507-14513
- **I. M. MIRON et al.** Fast current-induced domain-wall motion controlled by the Rashba effect. *Nat. Mater.*, 2011, vol. 10 (6), 419-423
- **K.-S. RYU** ; **L. THOMAS** ; **S.-H. YANG** ; **S. PARKIN**. Current induced tilting of domain walls in high velocity motion along perpendicularly magnetized microsized Co/Ni/Co racetracks.. *Appl. Phys. Expr.*, 2012, vol. 5 (9), 093006
- **S. EMORI** ; **U. BAUER** ; **S.-M. AHN** ; **E. MARTINEZ** ; **G. BEACH**. Current-driven dynamics of chiral ferromagnetic domain walls. *Nat. Mater.*, 2013, vol. 12 (7), 611-616
- **K.-S. RYU** ; **L. THOMAS** ; **S.-H. YANG** ; **S. PARKIN**. Chiral spin torque at magnetic domain walls. *Nat. Nanotechnol.*, 2013, vol. 8 (7), 527-533
- **S. VÉLEZ et al.** High-speed domain wall racetracks in a magnetic insulator. *Nat. Commun*, 2019, vol. 10 (1)

- **S.-H. YANG** ; **K.-S. RYU** ; **S. PARKIN**. Domain-wall velocities of up to 750 m s-1 driven by exchange-coupling torque in synthetic antiferromagnets.. *Nat. Nanotechnol.*, 2015, vol. 10 (3), 221-226
- **J.-G. ZHU** ; **X. ZHU** ; **Y. TANG**. Microwave assisted magnetic recording.. *IEEE Trans. Magn*, 2008, vol. 44 (1), 125-131
- **S. OKAMOTO** ; **N. KIKUCHI** ; **M. FURUTA** ; **O. KITAKAMI** ; **T. SHIMATSU**. Switching behaviors and its dynamics of a Co/Pt nanodot under the assistance of rf fields.. *Phys. Rev. Lett.*, 2012, vol. 109 (23), 237209
- **K. WAGNER et al.** Magnetic domain walls as reconfigurable spin-wave nanochannels.. *Nat. Nanotechnol.*, 2016, vol. 11 (5), 432-436
- **A. P. MALOZEMOFF** ; **J. C. SLONCZEWSKI**. Magnetic domain walls in bubble materials: advances in materials and device research. Academic Press, 1979
- **A. THIAVILLE** ; **J. M. GARCIA** ; **J. MILTAT**. Domain wall dynamics in nanowires.. *J. Magn. Magn. Mater.*, 2002, vol. 242, 1061-1063
- **A. THIAVILLE** ; **S. ROHART** ; **E. JUÉ** ; **V. CROS** ; **A. FERT**. Dynamics of Dzyaloshinskii domain walls in ultrathin magnetic films.. *Europhys. Lett.*, 2012, vol. 100 (5), 57002
- **S. EMORI** ; **U. BAUER** ; **S.-M. AHN** ; **E. MARTINEZ** ; **G. BEACH**. Current-driven dynamics of chiral ferromagnetic domain walls.. *Nat. Mater.*, 2013, vol. 12 (7), 611-616
- **N. L. SCHRYER** ; **L. R. WALKER**. The motion of 180° domain walls in uniform dc magnetic fields. *J. Appl. Phys.*, 1974, vol. 45 (12), 5406-5421
- **B. E. ARGYLE** ; **S. MAEKAWA** ; **P. DEKKER** ; **J. C. SLONCZEWSKI**. Gradientless propulsion and state switching of bubble domains. *AIP Conf. Proc.*, 1976
- **B. E. ARGYLE** ; **S. MAEKAWA** ; **P. DEKKER** ; **J. C. SLONCZEWSKI**. Gradientless propulsion and state switching of bubble domains.. *AIP Conf. Proc.*, 1976